# EUROPEAN PATENT SPECIFICATION

(11) **EP 3 685 446 B1**
(45) Date of publication and mention of the grant of the patent: **07.06.2023**
(21) Application number: 18812324.4
(22) Date of filing: 24.09.2018
(51) Int. Cl.: H01L 31/0224, H01L 31/0745, H01L 31/18

(54) **DOPANT ENHANCED SOLAR CELL AND METHOD OF MANUFACTURING THEREOF**
DOTIERSTOFFVERSTÄRKTE SOLARZELLE UND VERFAHREN ZU IHRER HERSTELLUNG
CELLULE SOLAIRE AMÉLIORÉE PAR DOPANT ET SON PROCÉDÉ DE FABRICATION

(30) Priority: 22.09.2017 NL 2019614
(43) Date of publication of application: 29.07.2020
(73) Proprietor: Nederlandse Organisatie voor toegepast- natuurwetenschappelijk Onderzoek TNO, 2595 DA Den Haag (NL)
(72) Inventor: STODOLNY, Maciej Krzyszto, 1755 LE Petten (NL); ANKER, John, 1755 LE Petten (NL); KOPPES, Martien, 1755 LE Petten (NL); ROMIJN, Ingrid Gerdina, 1755 LE Petten (NL); GEERLIGS, Lambert Johan, 1755 LE Petten (NL)
(74) Representative: Nederlandsch Octrooibureau
(86) International application number: PCT/NL2018/050632
(87) International publication number: WO 2019/059772

(56) References cited:
- WO-A1-2017/058011
- WO-A2-2017/058004
- HANDE E. ÇIFTPINAR ET AL: "Study of screen printed metallization for polysilicon based passivating contacts", ENERGY PROCEDIA, vol. 124, 1 September 2017 (2017-09-01), pages 851-861, XP055469386, NL ISSN: 1876-6102, DOI: 10.1016/j.egypro.2017.09.242 cited in the application

## Description

### Field of the invention

The present invention relates to a dopant enhanced solar cell based on a silicon substrate and method of manufacturing thereof.

### Background art

Doped polysilicon/thin oxide layer stacks (hereafter doped polySi/oxide stacks) can be used to form very high quality carrier-selective junctions for crystalline silicon cells, resulting in potentially very high cell efficiency. For contacting of the doped polysilicon (polySi) layer there are various options, such as fire-through (FT) paste, non-fire-through (NFT) paste, evaporated (PVD) metal, plated contacts and transparent conductive oxide (TCO).

A limiting effect on cell efficiency are recombination losses, which can occur at various locations throughout the stack, whereby current is lost between the solar power collecting surface and the contact.

Most preferred and therefore dominantly used contacts are FT contacts, i.e. contacts based on a FT paste, due to their low-cost and established technology. A downside of FT contacts, however, is that their application on doped polySi/oxide stacks often results in increased recombination at the location of the interface between the wafer and tunnel oxide layer, lowering cell efficiency. As a result, it is highly desirable to establish how FT contacts can be applied on doped polySi/oxide stacks with very limited resulting recombination at the location of the interface.

One known solution has been disclosed by Ciftpinar et al. in Proceedings of the 7th International Conference on Crystalline Silicon Photovoltaics (SiPV2017, April 2017, Freiburg, Germany), to be published in Energy Procedia, which is to use relatively thick polySi. However, the use of relatively thick polySi is disadvantageous for process cost, and for cell efficiency from the point of view of optical free carrier absorption losses.

WO 2017/058011 A1 describes a method of manufacturing of a solar cell comprising the steps of; providing a semiconductor substrate comprising an electrically conductive region extending at a first side thereof; and providing a tunnelling oxide (13) by thermal oxidation followed by a boron doped poly-silicon LPCVD deposited layer on the second side of the semiconductor substrate. Herein, the provision of the doped poly-silicon layer comprises depositing a multilayer stack of first sublayers of silicon and second sublayers of boron dopant in alternation, and subsequent annealing.

It is an object of the present invention to provide an efficient solar cell structure based on a silicon substrate and method of manufacturing thereof with, in comparison to the prior art, limited recombination of a FT metal contact.

### Summary of the invention

According to the present invention, a solar cell as defined above is provided, in which the solar cell based on a silicon substrate, comprises on a surface of the silicon substrate a layer stack comprising a thin oxide layer and a polysilicon layer, the silicon dioxide layer being arranged as a tunnel oxide layer inbetween said surface of the silicon substrate and the polysilicon layer; the solar cell being provided with metal contacts arranged on the layer stack locally penetrating into the polysilicon layer; wherein the silicon substrate is provided at the side of said surface with a dopant species that creates a dopant profile of a first dopant species of a first conductivity type in the silicon substrate, and the dopant profile of the first dopant species in the silicon substrate has a maximal dopant level between about 1×10⁺¹⁸ and about 3×10⁺¹⁹ atoms/cm³ and at a depth of at least 200 nm within the silicon substrate has a dopant atom level of 1×10⁺¹⁷ atoms/cm³.

The presence of this doping profile in the silicon substrate limits the recombination at the location of the metal contacts without requiring high polySi layer thicknesses and thus positively affects efficiency of the solar cell.

In a further embodiment the polysilicon layer is provided with a second dopant species of the first conductivity type having a dopant level in the polysilicon layer above the maximal dopant level in the silicon substrate. As a result, a positive differential exists across the thin oxide (or tunnel oxide) layer, creating "pull", which ensures good transmission of charge carriers of the first conductivity type across the tunnel oxide layer from the silicon substrate towards the polysilicon layer. As a result, the efficiency of the solar cell is increased.

Here, the maximal dopant level in the silicon substrate as described above, is to be measured at about 15 nm below the interface of the thin oxide layer and the substrate. The dopant level is determined by analytical method and equipment as known in the art.

According to a further embodiment the depth of the dopant profile to the dopant level of 10⁺¹⁷ atoms/cm⁺³ is between about 200 nm and about 1 µm. The thinner the polysilicon layer, the more dopant profile tail is required to obtain a solar cell in which the recombination is sufficiently limited. However, once the tail becomes too long or too highly doped, the positive effect limiting recombination is lost.

In an embodiment, the metal contacts are based on a fire-through metal paste. It is generally accepted that FT contacting technology is a well-established and low-cost technology, thus use of such contacts in the present invention provide better compatibility with present industrial manufacturing and lower costs. Additional advantage of FT contact technology is that it includes application of hydrogen-rich dielectric coating, which could be selected from PECVD SiNₓ:H and AL₂O₃, and so-called "firing", which results in hydrogenation of the polySi/oxide stack, thereby favourably increasing the passivation performance of the layer stack. Due to the specific doping profile of the layer stack including dopant profile tail, the application of FT contacts on these doped polySi/oxide stacks only has very limited resulting recombination at the location of the interface, also when at some points metal is in direct contact with the silicon wafer (i.e., even without separating layer of interfacial oxide or polySi between the metal and wafer). Thus the combination of the doping profile throughout the stack and the use of FT contacts results in a desirably efficient solar cell with low manufacturing cost.

Furthermore, in an embodiment the dopant profile in the silicon substrate as function of depth in the silicon substrate can be without being bound to any specific theory described to a good approximation by a Gaussian profile with the maximal dopant level positioned in the silicon substrate at a first distance from the interface of the silicon substrate and the thin oxide layer, and the maximal dopant level of the dopant species in the silicon substrate is lower than an average dopant level of the dopant species in the polysilicon layer by a factor of three or more. The average dopant level is determined as an average over the thickness of the polysilicon layer.

In some embodiments, the dopant species in the polysilicon layer may be identical to the dopant species in the silicon substrate. Alternatively, the dopant species in the polysilicon layer and in the silicon substrate may be different from each other. What is further claimed is a method for manufacturing a solar cell based on a silicon substrate as described above.

### Brief description of the drawings

The present invention will be discussed in more detail below, with reference to the attached drawings, in which:
Fig. 1 depicts a cross-section of a polysilicon passivated solar cell with a metal contact.
Fig. 2 shows a doping profile of a solar cell according to an embodiment.
Fig. 3A, 3B and 3C show respective flow diagrams for manufacturing a silicon substrate based solar cell with a polysilicon passivated contact stack and a metal contact according to an embodiment.

### Description of embodiments

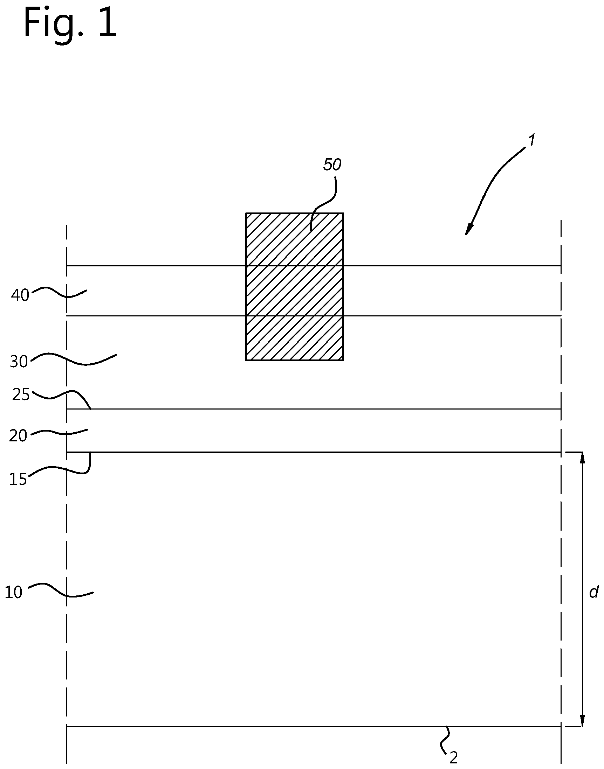

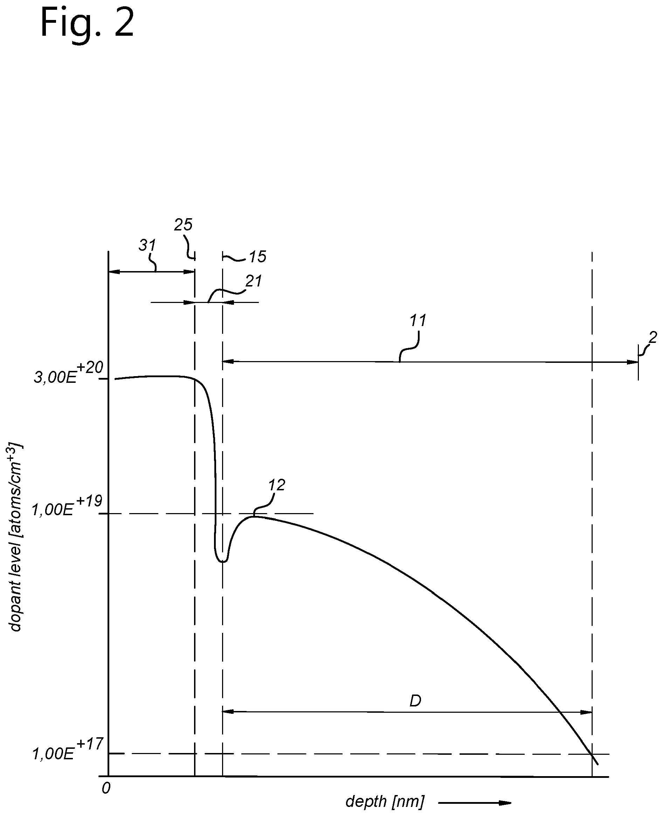

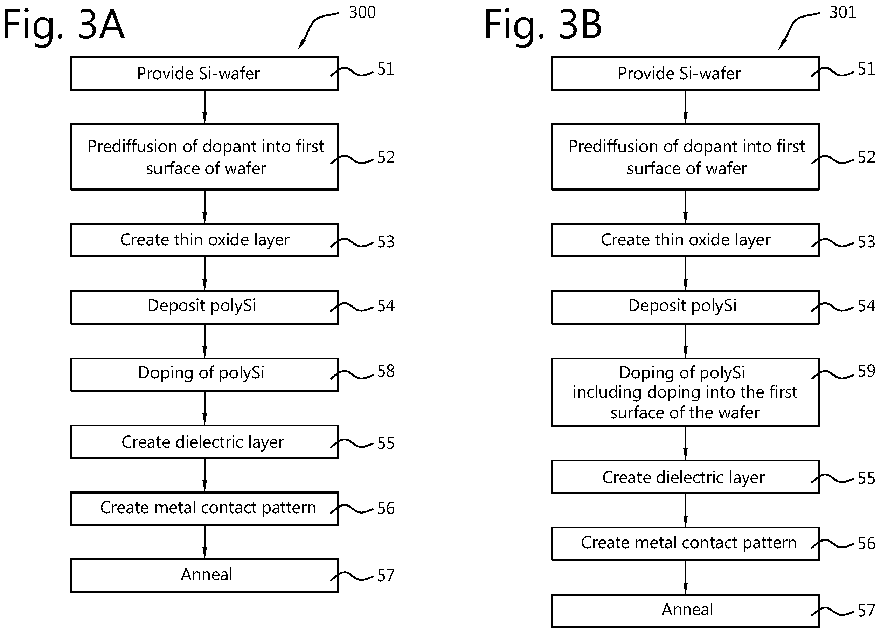

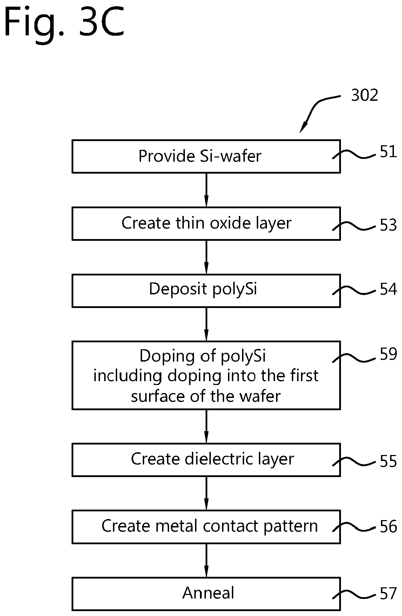

Figure 1 depicts a cross-section of a polysilicon passivated solar cell with a metal contact. The solar cell layer stack 1 comprises a silicon substrate 10, a tunnel oxide layer 20, a polysilicon layer 30, an dielectric coating layer 40 and a metal contact 50.
The silicon substrate 10 has a front surface 2, intended for facing the Sun when in use, and a rear surface onto which a tunnel oxide layer 20 has been created. A thin oxide is commonly used as tunnel oxide material. The layer has a minimum thickness of about 1 nm, 3 atomic layers, and is maximised at around 5 nm. The silicon substrate is a doped silicon wafer, which has been doped in a pre-diffusion step and/or during doping of polySi resulting in the claimed dopant profile which is discussed with reference to figures 2 and 3. The thin oxide layer may be a silicon oxide or metal oxide and may contain other additional elements such as nitrogen. The thin oxide layer may in actual effect not be a perfect tunnel barrier, as it can e.g. contain imperfections such as pinholes, which can result in other charge carrier transport mechanisms (such as drift, diffusion) dominating over tunneling.

On top of the thin oxide layer 20, the polysilicon layer 30 has been deposited, such that the surface interface of the thin oxide layer and the silicon substrate 15 comprises the front surface of the thin oxide layer and the surface interface of the tunnel oxide layer and the polysilicon layer 25 comprises the rear surface of the thin oxide layer. The polysilicon layer is a doped layer, preferably of the n-type, created by a phosphorus dopant. However, a p-type dopant species such as boron dopant may also be used, resulting in a p-type doped layer. Further, the polysilicon layer may contain other additional elements such as carbon or oxygen atoms.

The anti-reflection layer 40, usually an anti-reflective coating, covers the free surface of the polysilicon layer. A metal contact 50 has been applied on the solar cell layer stack 1 such that it protrudes the anti-reflection layer 40 and part of the polysilicon layer 30. The metal contact is preferably a fire-through paste contact, since it is a low cost contact that can be applied using well established manufacturing technology, thereby contributing to the affordability of efficient solar cells. A FT metal contact may locally fully penetrate the polySi or the polySi as well as the thin oxide, resulting in local contacts between the metal and the Si substrate. This may enhance the intimate electrical contact between the FT contact and the substrate for charge carrier collection, improving the series resistance of the cell.

Figure 2 shows a doping profile of a solar cell according to an embodiment. The doping profile is defined as the dopant level in atoms/cm⁺³ over the depth of the solar cell layer stack, from the polysilicon - anti-reflective layer interface towards the front surface 2. The profile can be split into three characterising sections, which correspond to layers of the solar cell stack presented in figure 1.

The first section 31 represents the dopant profile in the polysilicon layer , which is delimited by the interface 25 of the silicon dioxide layer and the polysilicon layer. The dopant level of the polysilicon layer is between about 1×10⁺²⁰ and about 3×10⁺²⁰ atoms/cm⁺³ and may be p- or n-type, depending on the base conductivity type of the silicon substrate.

The second section 21 represents the dopant profile around and within the tunnel oxide layer , which is delimited on the first side by the interface 25 of the thin oxide layer and the polysilicon layer and on the second side by the interface 15 of the thin oxide layer and the silicon substrate. In this second section, the profile comprises a drop with inflection point, in the profile between the doped polysilicon and the profile in the silicon substrate, substantially across the thin oxide layer.

It should be noted that the dopant profile around and within the thin oxide layer is normally an laterally averaged quantity, as it is known that e.g. pinholes in the thin oxide can result in microscopic local lateral variations of the dopant concentration. A measurement method such as electrochemical profiling (ECV) or secondary ion mass spectrometry (SIMS) will show this laterally averaged quantity.

The third section 11 represents the dopant profile within the silicon substrate , also called tail. The profile of the tail comprises a tail depth D of at least 200nm, optionally upto about 1000 nm, as measured from the polysilicon interface up to a depth position where the dopant level is 1×10⁺¹⁷ atoms/cm³, and a peak dopant level in the silicon substrate of between 1×10⁺¹⁸ and 3×10⁺¹⁹ atoms/cm³. Thus the maximum, i.e., the peak dopant level, 12 is at least a factor three lower than the average dopant level in the polysilicon layer. The peak dopant level 12 should be determined sufficiently far away from the interface 15, e.g. 15 nm, to avoid smearing effects from measurement artefacts. For thinner layers of polysilicon the tail depth D is preferably larger than 200 nm to reach the desired effect of limited recombination at the interface 15.

As previously described, the dopant used is either be p-type or n-type, although n-type may be preferred. Obtaining the desired and required dopant profile tail may be an easier controllable process in n-type polysilicon.

Figures 3A, 3B and 3C show respective flow diagrams 300, 301 and 302 for manufacturing a polysilicon passivated contact stack with a metal contact according to embodiments of the invention.

In Figure 3A, the manufacturing 300 starts with 51 the provision of a silicon substrate 10, also called wafer. Then a first doping step is performed through pre-diffusion 52 of a dopant species into a first surface of the silicon substrate for example by elevated temperature solid source diffusion whereby a dopant glass layer is applied followed by annealing and subsequent removal of the glass layer. By annealing at a pre-set temperature for a predetermined amount of time the first dopant species diffuses into the substrate such that the first dopant species profile meets the requirements set forth for the third section 11 presented in figure 2. Thus the dopant profile in the silicon substrate is created under such conditions that the dopant profile has a maximal dopant level between about 1×10⁺¹⁸ and about 3×10⁺¹⁹ atoms/cm³ and a depth of at least 200 nm to dopant atom level of 1×10⁺¹⁷ atoms/cm³. Alternative processes that may be used for the creation of the dopant profile in the silicon substrate are: elevated temperature gas source diffusion of dopant or ion-implantation of dopant.

Further, this step may comprise a partial etch back of the silicon substrate after doping before later provision of the layer stack, to ensure the dopant profile indeed has a maximum concentration between 1×10⁺¹⁸ and about 3×10⁺¹⁹ atoms/cm³ and a depth of at least 200 nm to dopant atom level of 1×10⁺¹⁷ atoms/cm³.

In a next step 53 a thin oxide layer is created on the same surface the pre-diffusion step was previously performed on. The thin oxide layer is created by a process selected from a group comprising atomic layer deposition, high temperature oxidation or wet chemical oxidation, ozone oxidation, plasma oxidation, and consists of at least silicon oxide.

The following step 54 comprises the deposition of a polysilicon (polySi), using a chemical or physical vapour deposition process. This polysilicon layer is then doped 58 in a second doping step, using the same dopant as the first dopant species used for doping the silicon substrate, whereby the dopant profile as described for the first section 31 of figure 2 is created by a process selected from a group comprising co-deposition, ion-implantation, gas source diffusion or solid source diffusion. The process may include an anneal (e.g. implant activation anneal).

Next, a dielectric coating layer, preferably hydrogen-rich, is created 55 on the surface of the polysilicon layer facing away from the silicon substrate.

This step is followed by 56 creating on the dielectric coating layer a metal contact pattern which locally penetrates into the polysilicon layer. The metal contacts are created from a pattern of fire-through metal paste on the layer stack by a fire-through annealing step 57. The fire-through annealing step is carried out under conditions such that the metal contacts do not penetrate into the silicon dioxide layer or the silicon substrate. Alternatively, the fire-through annealing step results in metal contacts locally penetrating the polySi or the thin oxide and touching the silicon substrate, resulting in local direct contacts between the metal and the silicon substrate. Furthermore, the fire-through annealing step 57 is carried out such that the dopant profile in the silicon substrate is not significantly affected meaning that further diffusion of the dopant species in the silicon substrate is negligible.

Alternatively, the manufacturing process 301 may follow the steps shown in Figure 3B. In this process, the pre-diffusion of a first species dopant 52 into a first surface of the silicon substrate only results in an initial doping profile within the substrate. The second doping step 59 is changed such that the polysilicon layer is doped, using the same dopant species as used for doping the silicon substrate, whereby the dopant also penetrates into the first surface of the silicon substrate.

In a further alternative manufacturing process 302, shown in Figure 3C, no first doping step is used. Instead, the doping profile meeting the requirements discussed under Figure 2 is created in a single step 59, whereby doping of the polysilicon layer also includes doping into the first surface of the silicon substrate.

In each of the manufacturing processes 300, 301, 302 the dopant species profile in the silicon substrate is tuned to the meet the requirements set forth as above at the stage before metallization, e.g. after later process steps to dope and anneal the polySi layer.

The invention has been described with reference to the preferred embodiments. Although the dopant enhanced solar cell is described as having FT contacts, the invention is not limited thereto. The invented dopant profile is likely to provide a significant advantage or improvement for solar cells having contacts applied with technologies other than FT, firing through.

Also, although the invention has been described with respect to back side contacts of the solar cell, the invention can also be beneficially applied to contacts on a front side of a solar cell.

Further obvious modifications and alterations will occur to others upon reading and understanding the preceding detailed description. It is intended that the invention be construed as including all such modifications and alterations insofar as they come within the scope of the appended claims.

## Claims

1. A solar cell (1) based on a silicon substrate (10), comprising on a surface of the silicon substrate a layer stack comprising a thin oxide layer and a polysilicon layer (30), the thin oxide layer being arranged as a tunnel oxide layer (20) in-between said surface of the silicon substrate and the polysilicon layer; the solar cell being provided with metal contacts (50) arranged on the layer stack locally penetrating into the polysilicon layer,
wherein the silicon substrate is provided at the side of said surface with a dopant species that creates a dopant profile of a first dopant species of a first conductivity type in the silicon substrate, **characterized in that** the dopant profile of the first dopant species in the silicon substrate has a maximal dopant level between about 1×10⁺¹⁸ and about 3×10⁺¹⁹ atoms/cm³ and at a depth of at least 200 nm within the silicon substrate has a dopant atom level of 1×10⁺¹⁷ atoms/cm³,
wherein the metal contacts are fire-through metal contacts that locally fully penetrate the polysilicon as well as the thin oxide, resulting in local contacts between the metal and the silicon substrate, such that the metal contacts are locally in direct contact with the silicon substrate.

2. The solar cell according to claim 1, wherein the polysilicon layer is provided with a second dopant species of the first conductivity type having a dopant level in the polysilicon layer above the maximal dopant level in the silicon substrate.

3. The solar cell according to claim 2, wherein the dopant level in the polysilicon layer is between about 1 ×10⁺²⁰ and about 3 ×10⁺²⁰ atoms/cm³.

4. The solar cell according to claim 2 or 3, wherein the dopant level has a decreasing gradient between the polysilicon layer and the silicon substrate, across the thin oxide layer.

5. The solar cell according to any one of the preceding claims, wherein the maximal dopant level in the silicon substrate is measured at about 50 nm below the interface of the thin oxide layer and the substrate.

6. The solar cell according to any one of the preceding claims, wherein the depth of the dopant profile to the dopant level of 10⁺¹⁷ atoms/cm³ is between about 200 nm and about 1 µm.

7. The solar cell according to any one of the preceding claims, wherein the layer stack further comprises an hydrogen-rich dielectric coating layer (40) on the surface of the polysilicon layer facing away from the silicon substrate.

8. The solar cell according to claim 7, wherein the hydrogen rich coating layer is selected from a group comprising a SiNₓ:H layer and an Al₂O₃ layer.

9. The solar cell according to any one of claims 1-8, wherein the metal contacts are fire-through contacts, which penetrate during the firing step through a dielectric coating layer and into the polysilicon layer and are based on a fire-through metal paste.

10. The solar cell according to claim 4, wherein the dopant profile in the silicon substrate as function of depth in the silicon substrate is described by a Gaussian profile with the maximal dopant level positioned in the silicon substrate at a first distance from the interface of the silicon substrate and the thin oxide layer, and the maximal dopant level of the first dopant species in the silicon substrate is lower than an average dopant level of the second dopant species in the polysilicon layer by a factor of three or more.

11. The solar cell according to any one of the preceding claims 1 - 10, wherein the second dopant species in the polysilicon layer is identical to the first dopant species in the silicon substrate.

12. The solar cell according to any one of the preceding claims, wherein the first conductivity type is n-type, and the first dopant species and second dopant species are each selected from a group comprising P, As, and Sb.

13. A method (300; 301; 302) for manufacturing a solar cell based on a silicon substrate, comprising:
providing the silicon substrate (51);
creating on said surface a layer stack comprising:
creating a thin oxide layer (53) on a surface of the silicon substrate,
and creating a doped polysilicon layer (54, 59) on the thin oxide layer, the doped polysilicon layer containing a dopant species of a first conductivity type,
such that the layer stack comprises the thin oxide layer arranged as a tunnel oxide layer in-between said surface of the silicon substrate and the doped polysilicon layer;
the method further comprising:
creating in a surface of the silicon substrate a dopant profile (52) of a dopant species of the first conductivity type,
**characterized by** the creation of the dopant profile in the silicon substrate is done either in a first process preceding the creation of the doped polysilicon layer or in a second process simultaneously during the creation of the doped polysilicon layer, and wherein the dopant profile in the silicon substrate is created under such conditions that the dopant profile of the dopant species of the first conductivity type in the silicon substrate has a maximal dopant level between about 1×10⁺¹⁸ and about 3×10⁺¹⁹ atoms/cm³ and at a depth of at least 200 nm within the silicon substrate has a dopant atom level of about 1×10⁺¹⁷ atoms/cm³,
wherein the method comprises
creating on the layer stack metal contacts that locally penetrate into at least the polysilicon layer, wherein the metal contacts are created from a pattern of fire-through metal paste (56) on the layer stack by a fire-through annealing step (57), such that
the metal contacts are fire-through metal contacts that locally fully penetrate the polysilicon as well as the thin oxide, resulting in local contacts between the metal and the silicon substrate, and the metal contacts are locally in direct contact with the silicon substrate.

14. The method according to claim 13, further comprising: preceding the creation of the dopant profile in the silicon substrate, creating in the layer stack an anti-reflective layer on the surface of the polysilicon layer that is facing away from the silicon substrate.

15. The method according to claim 13 or 14, further comprising:
providing a dopant level of the dopant species of the first conductivity type in the polysilicon layer under such conditions that a dopant level in the polysilicon layer is above the maximal dopant level in the silicon substrate.

16. The method according to any one of claims 13-15 wherein the maximal dopant level and the dopant atom level at the depth of at least 200 nm are obtained after completion of the doping and activation of the doped polysilicon layer.

17. The method according to claim 16, further comprising a partial etch back of the silicon substrate preceding the creation of the layer stack.

## Patentansprüche

1. Solarzelle (1) auf der Basis eines Siliciumsubstrats (10), die auf
einer Oberfläche des Siliciumsubstrats einen Schichtstapel aufweist,
der eine dünne Oxidschicht und eine Polysiliciumschicht (30) umfasst, wobei die dünne Oxidschicht als eine Tunneloxidschicht (20) zwischen der Oberfläche des Siliciumsubstrats und der Polysiliciumschicht angeordnet ist; wobei die Solarzelle mit Metallkontakten (50) bereitgestellt ist, die auf dem Schichtstapel angeordnet sind und lokal in die Polysiliciumschicht eindringen,
wobei das Siliciumsubstrat an der Seite der Oberfläche mit einer Dotierstoffspezies bereitgestellt ist, die ein Dotierstoffprofil einer ersten Dotierstoffspezies eines ersten Leitfähigkeitstyps in dem Siliciumsubstrat erzeugt, **dadurch gekennzeichnet, dass** das Dotierstoffprofil der ersten Dotierstoffspezies in dem Siliciumsubstrat ein maximales Dotierstoffniveau zwischen etwa 1 × 10⁺¹⁸ und etwa 3 × 10⁺¹⁹ Atome/cm³ aufweist und bei einer Tiefe von mindestens 200 nm innerhalb des Siliciumsubstrats ein Dotierstoffatomniveau von 1 × 10⁺¹⁷ Atome/cm³ aufweist,
wobei die Metallkontakte Durchbrennmetallkontakte sind, die lokal vollständig sowohl das Polysilicium als auch das dünne Oxid durchdringen, was zu lokalen Kontakten zwischen dem Metall und dem Siliciumsubstrat führt, so dass
die Metallkontakte lokal in direktem Kontakt mit dem Siliciumsubstrat stehen.

2. Solarzelle nach Anspruch 1, wobei die Polysiliciumschicht mit einer zweiten Dotierstoffspezies des ersten Leitfähigkeitstyps mit einem Dotierstoffniveau in der Polysiliciumschicht über dem maximalen Dotierstoffniveau im Siliciumsubstrat bereitgestellt ist.

3. Solarzelle nach Anspruch 2, wobei das Dotierstoffniveau in der Polysiliciumschicht zwischen etwa 1 × 10⁺²⁰ und etwa 3 × 10⁺²⁰ Atome/cm³ beträgt.

4. Solarzelle nach Anspruch 2 oder 3, wobei das Dotierstoffniveau zwischen der Polysiliciumschicht und dem Siliciumsubstrat über die dünne Oxidschicht einen abnehmenden Gradienten aufweist.

5. Solarzelle nach einem der vorhergehenden Ansprüche, wobei das maximale Dotierungsniveau im Siliciumsubstrat bei etwa 50 nm unterhalb der Grenzfläche zwischen der dünnen Oxidschicht und dem Substrat gemessen wird.

6. Solarzelle nach einem der vorhergehenden Ansprüche, wobei die Tiefe des Dotierstoffprofils zum Dotierstoffniveau von 10⁺¹⁷ Atome/cm³ zwischen etwa 200 nm und etwa 1 µm liegt.

7. Solarzelle nach einem der vorhergehenden Ansprüche, wobei der Schichtstapel ferner eine wasserstoffreiche dielektrische Beschichtungsschicht (40) auf der dem Siliciumsubstrat abgewandten Oberfläche der Polysiliciumschicht aufweist.

8. Solarzelle nach Anspruch 7, wobei die wasserstoffreiche Beschichtungsschicht aus einer Gruppe ausgewählt ist, die eine SiNₓ:H-Schicht und eine Al₂O₃-Schicht umfasst.

9. Solarzelle nach einem der Ansprüche 1 - 8, wobei die Metallkontakte Durchbrennkontakte sind, die während des Brennschrittes durch eine dielektrische Beschichtung und in die Polysiliciumschicht eindringen und auf einer Durchbrennmetallpaste basieren.

10. Solarzelle nach Anspruch 4, wobei das Dotierstoffprofil in dem Siliciumsubstrat als Funktion der Tiefe in dem Siliciumsubstrat durch ein Gauß-Profil beschrieben wird, wobei das maximale Dotierstoffniveau in dem Siliciumsubstrat in einem ersten Abstand von der Grenzfläche des Siliciumsubstrats und der dünnen Oxidschicht positioniert ist und das maximale Dotierstoffniveau der ersten Dotierstoffspezies in dem Siliciumsubstrat um einen Faktor von drei oder mehr niedriger ist als ein durchschnittliches Dotierstoffniveau der zweiten Dotierstoffspezies in der Polysiliciumschicht.

11. Solarzelle nach einem der vorhergehenden Ansprüche 1 - 10, wobei die zweite Dotierspezies in der Polysiliciumschicht mit der ersten Dotierspezies im Siliciumsubstrat identisch ist.

12. Solarzelle nach einem der vorhergehenden Ansprüche, wobei der erste Leitfähigkeitstyp vom n-Typ ist und die erste Dotierungsspezies und die zweite Dotierungsspezies jeweils aus einer Gruppe ausgewählt sind, die P, As und Sb umfasst.

13. Verfahren (300; 301; 302) zur Herstellung einer Solarzelle auf der Basis eines Siliciumsubstrats, umfassend:
Bereitstellen des Siliciumsubstrats (51);
Erzeugen eines Schichtstapels auf der genannten Oberfläche, umfassend:
Erzeugung einer dünnen Oxidschicht (53) auf einer Oberfläche des Siliciumsubstrats, und Erzeugen einer dotierten Polysiliciumschicht (54, 59) auf der dünnen Oxidschicht, wobei die dotierte Polysiliciumschicht eine Dotierspezies eines ersten Leitfähigkeitstyps enthält, so dass der Schichtstapel die dünne Oxidschicht umfasst, die als eine Tunneloxidschicht zwischen der Oberfläche des Siliciumsubstrats und der dotierten Polysiliciumschicht angeordnet ist;
wobei das Verfahren ferner umfasst:
Erzeugen eines Dotierstoffprofils (52) einer Dotierstoffspezies des ersten Leitfähigkeitstyps in einer Oberfläche des Siliciumsubstrats,
**gekennzeichnet durch** die Erzeugung des Dotierstoffprofils im Siliciumsubstrat entweder in einem ersten Prozess, der der Erzeugung der dotierten Polysiliciumschicht vorausgeht, oder in einem zweiten Prozess gleichzeitig während der Erzeugung der dotierten Polysiliciumschicht, und wobei das Dotierstoffprofil in dem Siliciumsubstrat unter solchen Bedingungen erzeugt wird, dass das Dotierstoffprofil der Dotierstoffspezies des ersten Leitfähigkeitstyps in dem Siliciumsubstrat ein maximales Dotierstoffniveau zwischen etwa 1 × 10⁺¹⁸ und etwa 3 × 10⁺¹⁹ Atome/cm³ und bei einer Tiefe von mindestens 200 nm innerhalb des Siliciumsubstrats ein Dotierstoffatomniveau von etwa 1 × 10⁺¹⁷ Atome/cm³ aufweist, wobei das Verfahren umfasst
Erzeugen von Metallkontakten auf dem Schichtstapel, die lokal in mindestens die Polysiliciumschicht eindringen, wobei die Metallkontakte aus einem Muster von Durchbrennmetallpaste (56) auf dem Schichtstapel durch einen Durchbrennglühschritt (57) erzeugt werden, so dass
die Metallkontakte Durchbrennmetallkontakte sind, die das Polysilicium sowie das dünne Oxid lokal vollständig durchdringen, was zu lokalen Kontakten zwischen dem Metall und dem Siliciumsubstrat führt, und die Metallkontakte lokal in direktem Kontakt mit das Siliciumsubstrat stehen.

14. Verfahren nach Anspruch 13, das ferner umfasst: vor der Erzeugung des Dotierstoffprofils in dem Siliciumsubstrat, Erzeugen einer Antireflektivschicht in dem Schichtstapel auf der Oberfläche der Polysiliciumschicht, die von dem Siliciumsubstrat abgewandt ist.

15. Verfahren nach Anspruch 13 oder 14, das ferner umfasst:
Bereitstellen eines Dotierstoffniveaus der Dotierstoffspezies des ersten Leitfähigkeitstyps in der Polysiliciumschicht unter solchen Bedingungen, dass ein Dotierstoffniveau in der Polysiliciumschicht über dem maximalen Dotierstoffniveau in dem Siliciumsubstrat liegt.

16. Verfahren nach einem der Ansprüche 13-15, wobei das maximale Dotierstoffniveau und das Dotierstoffatomniveau bei einer Tiefe von zumindest 200 nm nach Abschluss der Dotierung und Aktivierung der dotierten Polysiliciumschicht erhalten werden.

17. Verfahren nach Anspruch 16, das ferner ein partielles Rückätzen des Siliciumsubstrats vor der Erzeugung des Schichtstapels umfasst.

## Revendications

1. - Cellule solaire (1) à base d'un substrat de silicium (10), comprenant sur une surface du substrat de silicium un empilement de couches comprenant une couche d'oxyde mince et une couche de polysilicium (30), la couche d'oxyde mince étant disposée sous la forme d'une couche d'oxyde tunnel (20) entre ladite surface du substrat de silicium et la couche de polysilicium ; la cellule solaire étant pourvue de contacts métalliques (50) disposés sur l'empilement de couches pénétrant localement dans la couche de polysilicium,
dans laquelle le substrat de silicium est pourvu sur le côté de ladite surface d'une espèce dopante qui crée un profil de dopant d'une première espèce dopante d'un premier type de conductivité dans le substrat de silicium, **caractérisée par le fait que** le profil de dopant de la première espèce dopante dans le substrat de silicium a un niveau de dopant maximal entre environ 1 × 10⁺¹⁸ et environ 3 × 10⁺¹⁹ atomes/cm³ et à une profondeur d'au moins 200 nm à l'intérieur du substrat de silicium a un niveau d'atomes dopants de 1 × 10⁺¹⁷ atomes/cm³,
dans laquelle les contacts métalliques sont des contacts métalliques de cuisson par diffusion qui, localement, pénètrent totalement le polysilicium ainsi que l'oxyde mince, conduisant à des contacts locaux entre le métal et le substrat de silicium, de telle sorte que les contacts métalliques sont localement en contact direct avec le substrat de silicium.

2. - Cellule solaire selon la revendication 1, dans laquelle la couche de polysilicium est pourvue d'une seconde espèce dopante du premier type de conductivité ayant un niveau de dopant dans la couche de polysilicium au-dessus du niveau de dopant maximal dans le substrat de silicium.

3. - Cellule solaire selon la revendication 2, dans laquelle le niveau de dopant dans la couche de polysilicium est entre environ 1 × 10⁺²⁰ et environ 3 × 10⁺²⁰ atomes/cm³.

4. - Cellule solaire selon l'une des revendications 2 ou 3, dans laquelle le niveau de dopant a un gradient décroissant entre la couche de polysilicium et le substrat de silicium, à travers la couche d'oxyde mince.

5. - Cellule solaire selon l'une quelconque des revendications précédentes, dans laquelle le niveau maximal de dopant dans le substrat de silicium est mesuré à environ 50 nm au-dessous de l'interface de la couche d'oxyde mince et du substrat.

6. - Cellule solaire selon l'une quelconque des revendications précédentes, dans laquelle la profondeur du profil de dopant jusqu'au niveau de dopant de 10⁺¹⁷ atomes/cm³ est entre environ 200 nm et environ 1 µm.

7. - Cellule solaire selon l'une quelconque des revendications précédentes, dans laquelle l'empilement de couches comprend en outre une couche (40) de revêtement diélectrique riche en hydrogène sur la surface de la couche de polysilicium située à l'opposé du substrat de silicium.

8. - Cellule solaire selon la revendication 7, dans laquelle la couche de revêtement riche en hydrogène est choisie dans un groupe comprenant une couche de SiNₓ:H et une couche d'Al₂O₃.

9. - Cellule solaire selon l'une quelconque des revendications 1 à 8, dans laquelle les contacts métalliques sont des contacts de cuisson par diffusion, qui pénètrent pendant l'étape de cuisson à travers une couche de revêtement diélectrique et dans la couche de polysilicium et sont à base d'une pâte métallique de cuisson par diffusion.

10. - Cellule solaire selon la revendication 4, dans laquelle le profil de dopant dans le substrat de silicium en fonction de la profondeur dans le substrat de silicium est décrit par un profil gaussien avec le niveau de dopant maximal positionné dans le substrat de silicium à une première distance de l'interface du substrat de silicium et de la couche d'oxyde mince, et le niveau de dopant maximal de la première espèce dopante dans le substrat de silicium est inférieur à un niveau de dopant moyen de la seconde espèce dopante dans la couche de polysilicium d'un facteur de trois ou plus.

11. - Cellule solaire selon l'une quelconque des revendications précédentes 1 à 10, dans laquelle la seconde espèce dopante dans la couche de polysilicium est identique à la première espèce dopante dans le substrat de silicium.

12. - Cellule solaire selon l'une quelconque des revendications précédentes, dans laquelle le premier type de conductivité est le type n, et la première espèce dopante et la seconde espèce dopante sont chacune choisies dans un groupe comprenant P, As et Sb.

13. - Procédé (300 ; 301 ; 302) de fabrication d'une cellule solaire à base d'un substrat de silicium, comprenant :
fournir le substrat de silicium (51) ;
créer sur ladite surface un empilement de couches comprenant :
créer une couche d'oxyde mince (53) sur une surface du substrat de silicium,
et créer une couche de polysilicium dopée (54, 59) sur la couche d'oxyde mince, la couche de polysilicium dopée contenant une espèce dopante d'un premier type de conductivité,
de telle sorte que l'empilement de couches comprend la couche d'oxyde mince disposée en tant que couche d'oxyde tunnel entre ladite surface du substrat de silicium et la couche de polysilicium dopée ;
le procédé comprenant en outre :
créer dans une surface du substrat de silicium un profil de dopant (52) d'une espèce dopante du premier type de conductivité,
**caractérisé par le fait que** la création du profil de dopant dans le substrat de silicium est effectuée soit dans un premier processus précédant la création de la couche de polysilicium dopée, soit dans un second processus simultanément pendant la création de la couche de polysilicium dopée, et dans lequel le profil de dopant dans le substrat de silicium est créé dans des conditions telles que le profil de dopant de l'espèce dopante du premier type de conductivité dans le substrat de silicium a un niveau de dopant maximal entre environ 1 × 10⁺¹⁸ et environ 3 × 10⁺¹⁹ atomes/cm³ et à une profondeur d'au moins 200 nm à l'intérieur du substrat de silicium a un niveau d'atomes dopants d'environ 1 × 10⁺¹⁷ atomes/cm³,
dans lequel le procédé comprend :
créer sur l'empilement de couches des contacts métalliques qui pénètrent localement dans au moins la couche de polysilicium, les contacts métalliques étant créés à partir d'un motif de pâte métallique de cuisson par diffusion (56) sur l'empilement de couches par une étape de recuit de cuisson par diffusion (57), de telle sorte que
les contacts métalliques sont des contacts métalliques de cuisson par diffusion qui, localement, pénètrent totalement le polysilicium ainsi que l'oxyde mince, conduisant à des contacts locaux entre le métal et le substrat de silicium, et les contacts métalliques sont localement en contact direct avec le substrat de silicium.

14. - Procédé selon la revendication 13, comprenant en outre : avant la création du profil de dopant dans le substrat de silicium, créer dans l'empilement de couches une couche antiréfléchissante sur la surface de la couche de polysilicium qui est située à l'opposé du substrat de silicium.

15. - Procédé selon l'une des revendications 13 ou 14, comprenant en outre :
fournir un niveau de dopant de l'espèce dopante du premier type de conductivité dans la couche de polysilicium dans des conditions telles qu'un niveau de dopant dans la couche de polysilicium est au-dessus du niveau de dopant maximal dans le substrat de silicium.

16. - Procédé selon l'une quelconque des revendications 13 à 15, dans lequel le niveau maximal de dopant et le niveau d'atomes de dopant à la profondeur d'au moins 200 nm sont obtenus après achèvement du dopage et de l'activation de la couche de polysilicium dopée.

17. - Procédé selon la revendication 16, comprenant en outre une gravure partielle en retrait du substrat de silicium avant la création de l'empilement de couches.
